# EUROPEAN PATENT APPLICATION

(11) **EP 4 495 207 A1**
(43) Date of publication of application: **22.01.2025**
(21) Application number: 23770366.5
(22) Date of filing: 27.02.2023
(51) Int. Cl.: C09K 11/08, C09K 11/65, C01B 32/15

(54) **PRODUCTION METHOD FOR CARBON QUANTUM DOTS**

(30) Priority: 18.03.2022 JP 2022044067
(71) Applicant: Kureha Corporation, Chuo-ku Tokyo 103-8552 (JP)
(72) Inventor: SAKURAI, Yuka, Tokyo 103-8552 (JP); SAKABE, Hiroshi, Tokyo 103-8552 (JP); ISHIZU, Masaki, Tokyo 103-8552 (JP); TAKAHASHI, Yuka, Tokyo 103-8552 (JP)
(74) Representative: Zimmermann & Partner Patentanwälte mbB
(86) International application number: PCT/JP2023/007112
(87) International publication number: WO 2023/176407

(57) **Abstract**

An object is to provide a simple production method for carbon quantum dots that mainly emit light having a wavelength of from 520 nm to 580 nm when irradiated with blue light. A method for producing carbon quantum dots to solve the above-described issue includes: preparing a mixture containing an organic compound and a boron compound, the organic compound having a reactive group and not containing a boron atom; and to preparing carbon quantum dots by heating the mixture with substantially no solvent in the presence of an alkali metal and/or an alkaline earth metal. An amount of nitrogen atoms contained in the organic compound is within a predetermined range, an amount of the boron compound is within a predetermined range, and a total amount of the alkali metal and the alkaline earth metal is within a specific range.

## Description

### TECHNICAL FIELD

The present invention relates to a method for producing carbon quantum dots.

### BACKGROUND ART

As white LEDs, devices have been known in which blue LEDs and an inorganic fluorescent material that is excited by light from the blue LEDs and emits yellow light (wavelengths of about from 520 nm to 580 nm) are combined. However, the inorganic fluorescent material is expensive, and there is a demand for development of a material that can replace the inorganic fluorescent material.

It is known that carbon quantum dots are stable carbon-based fine particles having a particle size of about from several nm to several 10 nm, and that some carbon quantum dots exhibit good fluorescence properties. In addition, there is also an advantage that they do not have to contain a rare element or the like, unlike the inorganic fluorescent material, and can be produced at a relatively low cost. In recent years, much research has been conducted on carbon quantum dots.

For example, Patent Document 1 describes carbon quantum dots whose maximum emission wavelength is 549 nm when irradiated with light having a wavelength of 479 nm. This document describes, as a production method for the carbon quantum dots, a method in which a solution obtained by dissolving a carbon source, a nitrogen source, and a boron source in ultrapure water is reacted under a high pressure at 200°C for 4 hours.

### CITATION LIST

### PATENT DOCUMENT

Patent Document 1: CN 112028053 A

### SUMMARY OF INVENTION

### TECHNICAL PROBLEM

However, in the method of Patent Document 1, a large amount of ultrapure water is required, and the reaction needs to be performed under a high pressure. Therefore, a very large amount of energy is required when carbon quantum dots are produced. In addition, in the above-described method, it is necessary to perform various steps such as centrifugation and filtration, leading to difficulty in efficiently producing carbon quantum dots.

The present invention has been made in view of the above issues. An object of the present invention is to provide a simple method for producing carbon quantum dots that mainly emit light having a wavelength of from 520 nm to 580 nm when irradiated with blue light.

### SOLUTION TO PROBLEM

The present invention provides a method for producing carbon quantum dots, which is a production method for carbon quantum dots that are solid at 25°C under 1 atm, the production method including: preparing a mixture including an organic compound and a boron compound, the organic compound having a reactive group and not containing a boron atom; and preparing carbon quantum dots by heating the mixture with substantially no solvent in the presence of an alkali metal and/or an alkaline earth metal, wherein an amount of nitrogen atoms contained in the organic compound is 30 mass% or more and 50 mass% or less with respect to a total amount of the organic compound; an amount of the boron compound is 50 mass% or more and 80 mass% or less with respect to a total amount of the organic compound and the boron compound; and a total amount of the alkali metal and the alkaline earth metal is 0.1 mol% or more and 30 mol% or less with respect to a sum of numbers of moles of carbon atoms and nitrogen atoms contained in the organic compound and the boron compound.

### ADVANTAGEOUS EFFECTS OF INVENTION

The production method for carbon quantum dots of the present invention makes it possible to easily produce carbon quantum dots that mainly emit light having a wavelength of from 520 nm to 580 nm when irradiated with blue light.

### DESCRIPTION OF EMBODIMENTS

In the present specification, numerical ranges indicated by "to" refer to numerical ranges including the numerical values described before and after "to".

The method for producing carbon quantum dots according to an embodiment of the present invention is a method for producing carbon quantum dots that are solid at 25°C under 1 atm. As described above, it has been known that carbon quantum dots having a maximum emission wavelength at a wavelength of from 520 nm to 580 nm when irradiated with blue light are produced by a hydrothermal synthesis method. However, the preparation of carbon quantum dots by the method involves issues such as complicated production process and much input energy and time required.

On the other hand, the present inventors' intensive studies have clarified that, in a method including: preparing a mixture including an organic compound and a boron compound, the organic compound having a reactive group and not containing a boron atom (mixture preparation step); and preparing carbon quantum dots by heating the mixture with substantially no solvent in the presence of an alkali metal and/or an alkaline earth metal (heating step), in which the amount of nitrogen atoms contained in the organic compound is within a predetermined range, the amount of the boron compound with respect to the amount of the organic compound and the boron compound is within a predetermined range, and further the amount of the alkali metal and the alkaline earth metal is within a predetermined range, carbon quantum dots that mainly emit fluorescence having a wavelength of from 520 nm to 580 nm when irradiated with blue light can be easily produced. As specific examples of the above method, two production methods will be described below. However, the production method for carbon quantum dots of the present invention is not limited to these methods.

### (1) First Production Method

A first production method for carbon quantum dots is a method including the mixture preparation step described above and the heating step described above, wherein an alkali metal and/or an alkaline earth metal are/is contained in one or both of the organic compound and the boron compound used in the mixture preparation step.

In the first production method, a mixture containing a carbon atom, a nitrogen atom, a boron atom, and an alkali metal and/or an alkaline earth metal is prepared in the mixture preparation step, and, in the heating step, the mixture is heated with substantially no solvent to prepare carbon quantum dots. The carbon quantum dots obtained by such a production method have a maximum emission wavelength in a wavelength range of 520 nm or more and 580 nm or less, and have a very sharp emission peak wavelength. The reason for this is not clear, but one of the factors is considered to be that a certain amount of an alkali metal or an alkaline earth metal, when being present at the time of generation of the carbon quantum dots, is incorporated into the carbon quantum dots and that the size of the carbon quantum dots is likely to fall within a desired range. In addition, it is considered that the alkali metal or the alkaline earth metal changes the electronic state of the carbon quantum dots by ionizing the functional group of the carbon quantum dots or coordinating to the functional group. It is considered that, when the amount of nitrogen atoms and the amount of the boron compound are within the predetermined ranges at this time, the size of the carbon quantum dots is likely to be controlled or the size of the carbon quantum dots is likely to be uniform, resulting in a sharp peak of the emission wavelength.

In addition, when carbon quantum dots are prepared in a large amount of a solvent as in the known document indicated above, the carbon quantum dots are likely to aggregate at the time of removal of the solvent, and quenching or the like may occur. Meanwhile, the production method described above does not require solvent removal, the carbon quantum dots are less likely to aggregate, and the quenching is less likely to occur. Furthermore, when carbon quantum dots are prepared through heating with substantially no solvent, in a case where the organic compound and the boron compound are solid at that time of heating, reaction sites of a condensation reaction to generate the carbon quantum dots are limited to contact points between the organic compound and the boron compound in a solid state. That is, the reaction sites of the condensation reaction are locally limited. Meanwhile, even if one or both of the organic compound and the boron compound is/are liquid during heating, viscosity of the mixture increases due to an increase in molecular weight caused by the condensation reaction. Therefore, also in this case, the reaction site of the condensation reaction becomes local as compared with a case where carbon quantum dots are prepared in a large amount of a solvent. Therefore, it is considered that the type and particle size of the carbon quantum dots to be generated are limited, resulting in a high emission quantum yield or a sharp peak of the emission wavelength.

Furthermore, when carbon quantum dots are produced by heating an organic compound and a boron compound with substantially no solvent as in the production method, an apparatus for controlling pressure and an apparatus for removing a solvent are not required, and the amount of input energy is very small. Therefore, desired carbon quantum dots can be efficiently and easily produced. Each step of the first production method will be described below.

### • Mixture Preparation Step

In the mixture preparation step, a mixture is prepared by mixing an organic compound which contains a reactive group and does not contain a boron atom, and a boron compound. In the present specification, the "reactive group" means a group bonding to a carbon atom in the organic compound, is a group for causing polycondensation reaction or the like of the organic compounds in the heating step described below, and is a group contributing to the formation of a main backbone of the carbon quantum dots. Specific examples of the reactive group include a carboxy group, a hydroxy group, an epoxy group, an amide group, a sulfo group, an amino group, and a group to which an alkali metal or an alkaline earth metal is bonded or coordinated. Furthermore, in the present specification, a compound containing a boron atom is referred to as "boron compound". Even when a molecule contains a reactive group, if the molecule contains a boron atom, the molecule is taken as a boron compound.

Here, one or both of the organic compound and the boron compound used in this step contain(s) an alkali metal and/or an alkaline earth metal. An amount of the alkali metal and the alkaline earth metal contained in the organic compound and the boron compound may be in a range in which the amount of the alkali metal and the alkaline earth metal in the heating step which will be described below falls within a desired range.

Here, the type of the alkali metal or alkaline earth metal contained in the organic compound or boron compound is not particularly limited, and examples thereof include lithium, sodium, potassium, magnesium, calcium, and barium. However, sodium, potassium, or calcium is preferred from the viewpoint of reactivity, safety, availability of a material, and the like.

The organic compound used in the mixture preparation step is only required to be a compound containing a reactive group, being capable of generating carbon quantum dots by carbonization (condensation reaction), and containing 30 mass% or more and 50 mass% or less of a nitrogen atom with respect to a total amount of the organic compound. The amount of nitrogen atoms is preferably 33 mass% or more and 50 mass% or less, and more preferably 36 mass% or more and 48 mass% or less. When the amount of nitrogen atoms in the organic compound is 30 mass% or more and 50 mass% or less, the peak of the emission wavelength of the carbon quantum dots tends to be sharp or the emission quantum yield tends to be high, as described above. The amount of nitrogen atoms in the organic compound can be specified from the structure of the organic compound.

The organic compound may contain only one compound, or two or more compounds. Specifically, the organic compound may contain only a compound containing a nitrogen atom and a reactive group (hereinafter, also referred to as "nitrogen-containing organic compound") or may contain a compound containing no nitrogen atom and containing a reactive group (hereinafter, also referred to as "nitrogen-free organic compound") and a nitrogen-containing organic compound.

Examples of the nitrogen-containing organic compound include amine compounds, nitrogen-containing saccharides, imidazoles, triazines, triazoles, triazenes, guanidines and oximes, and salts of these compounds with alkali metals and/or alkaline earth metals. The organic compound may contain only one of these, or two or more of these. Furthermore, these compounds may be in a solid or liquid state at normal temperature.

Examples of an amine compound include 1,2-phenylenediamine, 1,3-phenylenediamine, 1,4-phenylenediamine, 2,6-diaminopyridine, urea, thiourea, ammonium thiocyanate, ethanolamine, 1-amino-2-propanol, melamine, cyanuric acid, barbituric acid, folic acid, ethylenediamine, diethylenetriamine, triethylenetetramine, polyethyleneimine, dicyandiamide, guanidine, aminoguanidine, formamide, glutamic acid, aspartic acid, cysteine, arginine, histidine, lysine, glutathione, RNA, DNA, cysteamine, methionine, homocysteine, taurine, thiamine, N-[3-(trimethoxysilyl)propyl]ethylenediamine, and 4,5-difluoro-1,2-phenylenediamine, sulfanilic acid, o-phosphoserine, adenosine 5'-triphosphate, guanidine phosphate, guanylurea phosphate, and 3-aminopropyltriethoxysilane.

Examples of a nitrogen-containing saccharide include glucosamine, chitin, and chitosan. Examples of an imidazole include 1-(trimethylsilyl)imidazole. Examples of triazines include 1,2,4-triazine. Examples of triazoles include 1,3,5-triazine, 1,2,3-triazole, and 1,2,4-triazole. Examples of triazenes include 1,3-diphenyltriazene and 1-methyl-3-p-tolyltriazene. Examples of guanidines include guanidine and arginine. Examples of oximes include benzamidoxime and p-benzoquinone dioxime. Examples of alkali metal salts and alkaline earth metal salts of the above compounds include sodium glutamate and sodium imidazole-4-acetate.

Among these, a nitrogen-containing organic compound is preferably an amine compound from the perspectives of availability and reactivity in the heating step described below.

Meanwhile, examples of the nitrogen-free organic compound include carboxylic acids, alcohols, phenols and saccharides, and salts of these compounds with alkali metals and/or alkaline earth metals. The organic compound may contain only one of these, or two or more of these. Furthermore, these compounds may be in a solid or liquid state at normal temperature.

A carboxylic acid is any compound having one or more carboxy groups in the molecule (however, except those corresponding to nitrogen-containing organic compounds, phenols, or saccharides). Examples of a carboxylic acid include a monocarboxylic acid, such as formic acid, acetic acid, 3-mercaptopropionic acid, and α-lipoic acid; a polyvalent carboxylic acid that is divalent or higher, such as oxalic acid, malonic acid, succinic acid, maleic acid, fumaric acid, itaconic acid, polyacrylic acid, (ethylenedithio)diacetic acid, thiomalic acid, tetrafluoroterephthalic acid, and 2-phosphonobutane-1,2,4-tricarboxylic acid; and a hydroxy acid, such as citric acid, glycolic acid, lactic acid, tartaric acid, malic acid, and 5-sulfosalicylic acid.

The alcohol is preferably a monohydric alcohol having one hydroxy group and 6 or more carbons, or a polyhydric alcohol having two or more hydroxy groups (however, except those corresponding to nitrogen-containing organic compounds, carboxylic acids, phenols, or saccharides). Examples of a monohydric alcohol having 6 or more carbons include a higher alcohol such as hexanol or octanol. Meanwhile, examples of polyhydric alcohols include ethylene glycol, glycerol, erythritol, pentaerythritol, ascorbic acid, polyethylene glycol, and sorbitol.

Phenols are any compound having a structure in which a hydroxy group is bonded to a benzene ring (however, except nitrogen-containing organic compound). Examples of phenols include phenol, catechol, resorcinol, hydroquinone, phloroglucinol, pyrogallol, 1,2,4-trihydroxybenzene, gallic acid, tannin, lignin, catechin, anthocyanin, rutin, chlorogenic acid, lignan, and curcumin.

Examples of saccharides as a nitrogen-free organic compound include glucose, sucrose, and cellulose. Examples of alkali metal salts and alkaline earth metal salts of the above compounds include trisodium citrate dihydrate, tripotassium citrate monohydrate, sodium ascorbate, and calcium acetate.

The nitrogen-free organic compound preferably contains a reactive group that efficiently proceed a condensation reaction with the nitrogen-containing organic compound, and is preferably a carboxylic acid, an alcohol, a phenol, an alkali metal salt thereof, or an alkaline earth metal salt thereof. The amount of the nitrogen-free organic compound in the organic compound is appropriately selected in a manner that the amount of nitrogen atoms in the organic compound becomes 30 mass% or more and 50 mass% or less.

The total amount of the organic compound (the nitrogen-containing organic compound and the nitrogen-free organic compound) is only required to be 20 mass% or more and 50 mass% or less, and is preferably 35 mass% or more and 48 mass% or less, with respect to the total amount of the organic compound and the boron compound. When the amount of the organic compound with respect to the total amount of the organic compound and the boron compound falls within the above range, the peak of the emission wavelength tends to be sharp as described above.

The boron compound used in the preparation of the mixture is only required to be a compound containing a boron atom and may be, for example, elemental boron or a compound containing boron. The mixture prepared in this step may contain only one or two or more of the boron compounds.

Specific examples of a boron compound include boron, boric acid, sodium tetraborate, boric oxide, trimethyl borate, triethyl borate, trioctadecyl borate, triphenyl borate, 2-ethoxy-4,4,5,5-tetramethyl-1,3,2-dioxaborolane, triethanolamine borate, 2,4,6-trimethoxyboroxine, tris(trimethylsilyl) borate, tris(2-cyanoethyl) borate, 3-aminophenylboronic acid, 2-anthratheneboronic acid, 9-anthratheneboronic acid, phenylboronic acid, 3,5-bis(trifluoromethyl)phenylboronic acid, 4,4'-biphenyldiboronic acid, 2-bromophenylboronic acid, 4-bromo-1-naphthaleneboronic acid, 3-bromo-2-fluorophenylboronic acid, 4-carboxyphenylboronic acid, 3-cyanophenylboronic acid, 4-cyano-3-fluorophenylboronic acid, 3,5-difluorophenylboronic acid, 4-(diphenylamino)phenylboronic acid, 3-fluorophenylboronic acid, 3-hydroxyphenylboronic acid, 4-mercaptophenylboronic acid, 1-naphthaleneboronic acid, 9-phenanthreneboronic acid, 1,4-phenylenediboronic acid, 1-pyreneboronic acid, 2-aminopyrimidine-5-boronic acid, 2-bromopyridine-3-boronic acid, 2-fluoropyridine-3-boronic acid, 4-pyridylboronic acid, quinoline-8-boronic acid, 4-aminophenylboronic acid pinacol, 3-hydroxyphenylboronic acid pinacol, 4-(4,4,5,5-tetramethyl-1,3,2-dioxaborolan-2-yl)pyridine, diboronic acid, sodium borohydride, sodium tetrafluoroborate, 1-ethyl-3-methylimidazolium tetrafluoroborate, boron trifluoride, and boron tribromide.

Note that the amount of boron atoms in the boron compound is preferably 3 mass% or greater, and more preferably 5 mass% or greater, with respect to the total amount of the boron compound. When the amount of boron atoms in the boron compound is in the range described above, the boron atoms can be arranged on a surface of the carbon quantum dot, and the emission quantum yield tends to increase.

The total amount of the boron compound is only required to be 50 mass% or more and 80 mass% or less, and is preferably 50 mass% or more and 70 mass% or less, and more preferably 52 mass% or more and 65 mass% or less, with respect to the total amount of the organic compound and the boron compound. When the amount of the boron compound with respect to the total amount of the organic compound and the boron compound is 50 mass% or more, fluorescence is easily emitted, and the emission quantum yield is sufficiently increased, or the peak of the emission wavelength tends to be sharp.

Note that, in this step, a compound other than the organic compound and the boron compound may be further mixed as long as the object and effect of the present invention are not impaired. However, the amounts of the organic compound and the boron compound in the mixture are preferably 50 mass% or more, and more preferably 70 mass% or more, with respect to the total amount of the mixture. When the total amount of the organic compound and the boron compound is 50 mass% or more, the carbon quantum dots can be prepared efficiently. Note that the compound other than the organic compound and the boron compound may contain an alkali metal or an alkaline earth metal in such a range that the amount of the alkali metal and the alkaline earth metal in the heating step which will be described later falls within a desired range.

Furthermore, examples of the compound other than the organic compound and the boron compound include a compound containing a phosphorus atom, a sulfur atom, a silicon atom, a fluorine atom, or the like and containing no reactive group (hereinafter, also referred to as "another compound"). When such another compound is mixed in this step, carbon quantum dots containing a heteroatom besides nitrogen and boron can be obtained. The mixture may contain only one or two or more of such other compounds.

Examples of a compound containing a phosphorus atom include elemental phosphorus, phosphoric acid, phosphorus oxide, 1-hydroxyethane-1,1-diphosphonic acid, phytic acid, ammonium phosphate, diammonium hydrogen phosphate, ammonium dihydrogen phosphate, o-phosphorylethanolamine, phosphorus chloride, phosphorus bromide, triethyl phosphonoacetate, tetrakis(hydroxymethyl)phosphonium chloride, methyl phosphate, triethyl phosphite, nitrilotris(methylenephosphonic acid), and N,N,N',N'-ethylenediaminetetrakis(methylenephosphonic acid).

Examples of a compound containing a sulfur atom include sulfur, sodium thiosulfate, sodium sulfide, sodium sulfate, sulfuric acid, methane sulfonic acid, p-toluenesulfonic acid, and sodium hydrosulfide.

Examples of a compound containing a silicon atom include tetrachlorosilane and tetraethoxysilane.

Examples of a compound containing a fluorine atom include 2,2,3,3,4,4-hexafluoro-1 ,5-pentanediol diglycidyl ether and sodium fluoride.

The amount of such other compound in the mixture is appropriately selected based on the amount of the desired heteroatom and, typically, is preferably from 0 mass% to 20 mass%, and more preferably from 3 mass% to 10 mass%, with respect to the total amount of the mixture. When the amount of such other compound is 3 mass% or greater, addition effect of such another compound tends to be achieved. Meanwhile, when the amount of such other compound is 10 mass% or less, the amounts of the organic compound and the boron compound are relatively adequately increased, and thus the carbon quantum dots can be prepared more efficiently.

In this step, a layered clay mineral may be further added. When the layered clay mineral is added, carbon quantum dots having a uniform size can be easily prepared using an interlayer space of the layered clay mineral as a template. Examples of a layered clay mineral include a smectite, a layered double hydroxide, a kaolinite, and a mica. Preferred among these is a smectite or a layered double hydroxide in terms of having an average interlayer spacing appropriate for forming the carbon quantum dots. Although the layered clay mineral may contain an alkali metal or an alkaline earth metal, the alkali metal or the alkaline earth metal does not substantially affect the composition of the carbon quantum dots, and thus, in the present specification, the amount of the alkali metal or the alkaline earth metal contained in the layered clay mineral is not included in the amount of the alkali metal or the alkaline earth metal specified in the processing step.

The smectite is a clay mineral that swells with water or the like, and examples include saponite, montmorillonite, hectorite, beidellite, nontronite, sauconite, and stevensite.

Meanwhile, the layered double hydroxide is a double hydroxide obtained by forming a solid solution of a divalent metal oxide and a trivalent metal ion, and examples thereof include hydrotalcite, hydrocalumite, hydromagnesite, and pyroaurite.

To adjust the average interlayer spacing of the layered clay mineral, the layered clay mineral may be swelled with a solvent. Examples of a solvent include water, methanol, ethanol, hexane, toluene, chloroform, dimethylformamide, and dimethyl sulfoxide. However, in the heating step described below, heating is performed with substantially no solvent. Thus, the amount of the solvent is preferably small, and the boiling point of the solvent is preferably lower than the temperature at which the organic compound and the like are carbonized in the heating step (hereinafter, also referred to as "heating temperature"). In other words, the amount and the type of solvent are preferably adjusted in a manner that all the solvent is volatilized before the temperature of the mixture reaches the heating temperature in the heating step described below.

Note that the amount of the layered clay mineral in the mixture is preferably from 0 mass% to 20 mass%, and more preferably from 0 mass% to 10 mass%, with respect to the total amount of the mixture, and even more preferably, substantially no layered clay mineral is contained. Note that substantially not contained means 5 mass% or less with respect to the total amount of the mixture. Note that the amount of the layered clay mineral is more preferably 3 mass% or less, and even more preferably 1 mass% or less, with respect to the total amount of the mixture, and the layered clay mineral is particularly preferably not contained at all. When the amount of the layered clay mineral is 20 mass% or less, the amounts of the organic compound and the boron compound are relatively adequately large, and thus the carbon quantum dots can be prepared more efficiently.

The mixing method of the mixture is not particularly limited as long as the method can uniformly mix the organic compound, the boron compound, and optionally another compound and the layered clay mineral. For example, mixing may be performed while grinding is performed in a mortar, or mixing may be performed while crushing is performed by a ball mill or the like. Furthermore, in a case where the organic compound or the boron compound or another compound is a liquid, mixing may be performed by dissolving, blending, or dispersing a solid component in a liquid component. Alternatively, mixing may be performed by dissolving, blending, or dispersing each material in a small amount of a solvent. In this case, the amount and the type of the solvent are adjusted in a manner that heating in the heating step described below can be performed with substantially no solvent. Specifically, the amount and the type of the solvent are preferably adjusted in a manner that all the solvent is volatilized before the temperature of the mixture reaches the heating temperature. Note that, in the present specification, a solvent means a compound that is liquid under 1 atm at 25°C and that does not correspond to the organic compound and the boron compound described above.

### ▪ Heating Step

In the heating step, the mixture adjusted in the mixture preparation step described above is heated with substantially no solvent. In the present specification, "with substantially no solvent" means an amount of a solvent in the mixture being 5 mass% or less with respect to the total amount of the mixture at the time when a temperature reaches the temperature for carbonizing the organic compound and the like (heating temperature). The amount of the solvent in the mixture at the heating temperature is preferably 2 mass% or less, and even more preferably 0 mass%. Thus, as described above, as long as the solvent can be adequately volatilized before the heating temperature is reached, the mixture may contain a solvent at the start of the heating. Note that compounds that are raw materials of the carbon quantum dots, such as the organic compound and the boron compound, may be liquid at the heating temperature.

The heating step is performed in the presence of an alkali metal and/or an alkaline earth metal. Here, the total amount of the alkali metal and the alkaline earth metal in the mixture when the heating step is performed is only required to be 0.1 mol% or more and 30 mol% or less, and is preferably 0.5 mol% or more and 20 mol% or less, and more preferably 1 mol% or more and 10 mol% or less, with respect to the sum of the numbers of moles of carbon atoms and nitrogen atoms contained in the organic compound and the boron compound. The alkali metal and the alkaline earth metal in the mixture are mainly derived from the organic compound and the boron compound described above, but a part thereof may be derived from another compound in the mixture.

The heating method of the mixture is only required to be a method that can produce the carbon quantum dots by carbonizing the organic compound and the like, and examples thereof include heating by a heater and irradiation of electromagnetic wave.

In a case where the mixture is heated by a heater or the like, the heating temperature is preferably 70°C or higher and 700°C or lower, more preferably 100°C or higher and 500°C or lower, and even more preferably 100°C or higher and 300°C or lower. Furthermore, the retention time at the heating temperature is preferably 0.01 hours or longer and 45 hours or less, more preferably 0.1 hours or longer and 30 hours or less, and even more preferably 0.5 hours or longer and 10 hours or less. The particle size of the resulting carbon quantum dot and the emission wavelength can be adjusted by the heating time. Furthermore, here, heating may be performed in a non-oxidizing atmosphere while an inert gas such as nitrogen is circulated.

In the case where irradiation with an electromagnetic wave (e.g., microwave) is performed, the wattage is preferably 1 W or greater and 1500 W or less, and more preferably 1 W or greater to 1000 W or less. Furthermore, the heating time by the electromagnetic wave (e.g., microwave) is preferably 0.01 hours or longer and 10 hours or less, more preferably 0.01 hours or longer and 5 hours or less, and even more preferably 0.01 hours or longer and 1 hour or less. The particle size of the resulting carbon quantum dot and the emission wavelength can be adjusted by the irradiation time of the electromagnetic wave.

The electromagnetic wave irradiation can be performed by, for example, a semiconductor type electromagnetic wave radiation device. The irradiation with the electromagnetic wave is preferably performed while the temperature of the mixture is checked. For example, the electromagnetic wave irradiation is preferably performed while the heating temperature is adjusted to 70°C or higher and 700°C or lower.

By this step of heating, the carbon quantum dots are obtained. Note that unreacted boron compound and the like may remain around the carbon quantum dots. Thus, to isolate the carbon quantum dots, for example, the obtained component may be washed with an organic solvent or the like to purify the component by removal of unreacted materials or by-products.

### (2) Second Production Method

A second production method for carbon quantum dots is a method including preparing the mixture as described above, mixing the mixture and an aqueous solution containing an alkali metal and/or an alkaline earth metal (aqueous solution mixing step), and heating as described above. In the aqueous solution mixing step, an amount of the aqueous solution to be mixed with the mixture is 200 mass% or less with respect to an amount of the mixture.

In the second production method, a mixture containing at least a carbon atom, a nitrogen atom, and a boron atom is prepared in the mixture preparation step, the mixture and an aqueous solution containing an alkali metal and/or an alkaline earth metal are mixed in the aqueous solution mixing step, and heating is performed with substantially no solvent in the heating step to prepare carbon quantum dots. In the present specification, "with substantially no solvent" means an amount of a solvent in the mixture being 5 mass% or less with respect to the total amount of the mixture at the time when a temperature reaches the temperature for carbonizing the organic compound and the like (heating temperature), as described above. In the second production method, the aqueous solution containing an alkali metal and/or an alkaline earth metal is added in the aqueous solution mixing step. However, since the amount of the aqueous solution is sufficiently small, water in the aqueous solution is volatilized before the temperature reaches the heating temperature for carbonizing the organic compound and the like. Thus, the heating step can be performed with substantially no solvent.

For the same reason as in the first production method, the carbon quantum dots obtained by such a production method have a maximum emission wavelength in a wavelength range of 520 nm or more and 580 nm or less, and have a very sharp emission peak wavelength. In addition, as described above, when carbon quantum dots are prepared in a large amount of a solvent, the carbon quantum dots are likely to aggregate at the time of removal of the solvent, and quenching or the like may occur. On the other hand, as described above, when carbon quantum dots are prepared with substantially no solvent, the obtained carbon quantum dots are less likely to aggregate, and the quenching as described above is less likely to occur.

When carbon quantum dots are produced by mixing a mixture containing an organic compound and a boron compound with a relatively small amount of an aqueous solution as in the second production method, an apparatus for controlling pressure and an apparatus for removing a solvent are not required, and the amount of input energy is very small. Therefore, desired carbon quantum dots can be efficiently and easily produced. Each step of the second production method will be described below.

### • Mixture Preparation Step

In the mixture preparation step, a mixture is prepared by mixing an organic compound, which contains a reactive group and does not contain a boron atom, and a boron compound. The organic compound and the boron compound used in this step may or may not contain an alkali metal or an alkaline earth metal.

The organic compound used in the mixture preparation step may contain only one compound, or two or more compounds. That is, the organic compound may contain only a nitrogen-containing organic compound, or may be a mixture of a nitrogen-free organic compound and a nitrogen-containing organic compound. The nitrogen-containing organic compound and the nitrogen-free organic compound are the same as those described in the first production method.

The total amount of the organic compound (the nitrogen-containing organic compound and the nitrogen-free organic compound) is only required to be 20 mass% or more and 50 mass% or less, and is preferably 35 mass% or more and 48 mass% or less, with respect to the total amount of the organic compound and the boron compound. When the amount of the organic compound with respect to the total amount of the organic compound and the boron compound falls within the above range, the peak of the emission wavelength tends to be sharp as described above.

Meanwhile, the boron compound is only required to be a compound containing a boron atom and may be, for example, elemental boron or a compound containing boron. The mixture prepared in this step may contain only one or two or more of the boron compounds. The boron compound is the same as that described in the first production method.

The total amount of the boron compound is only required to be 50 mass% or more and 80 mass% or less, but is preferably 50 mass% or more and 70 mass% or less, and more preferably 52 mass% or more and 65 mass% or less, with respect to the total amount of the organic compound and the boron compound. When the amount of the boron compound with respect to the total amount of the organic compound and the boron compound is 50 mass% or more, fluorescence is easily emitted, and the emission quantum yield is sufficiently increased, or the peak of the emission wavelength tends to be sharp.

Note that, in this step, a compound other than the organic compound and the boron compound may be further mixed as long as the object and effect of the present invention are not impaired. However, the total amount of the organic compound and the boron compound in the mixture is preferably 50 mass% or more, and more preferably 70 mass% or more, with respect to the total amount of the mixture. When the total amount of the organic compound and the boron compound is 50 mass% or more, the carbon quantum dots can be prepared efficiently. The compound other than the organic compound and the boron compound is the same as that described in the first production method.

The mixing method of the mixture is not particularly limited as long as the method can uniformly mix the organic compound, the boron compound, and optionally another compound and the layered clay mineral. For example, mixing may be performed while grinding is performed in a mortar, or mixing may be performed while crushing is performed by a ball mill or the like. Furthermore, in a case where the organic compound or the boron compound or another compound is a liquid, mixing may be performed by dissolving, blending, or dispersing a solid component in a liquid component. Alternatively, mixing may be performed by dissolving, blending, or dispersing each material in a small amount of a solvent. In this case, the amount and the type of the solvent are adjusted in a manner that heating in the heating step described below can be performed with substantially no solvent. Specifically, the amount and the type of the solvent are preferably adjusted in a manner that all the solvent is volatilized before the temperature of the mixture reaches a desired heating temperature.

### • Aqueous Solution Mixing Step

The amount of the aqueous solution used in this step is only required to be 200 mass% or less, and is preferably 150 mass% or less, with respect to the mass of the mixture. When the amount of the aqueous solution falls within the above range, all the water is evaporated before the temperature of the mixture reaches a desired heating temperature. Therefore, carbon quantum dots can be prepared with substantially no solvent.

Here, the types of the alkali metal and alkaline earth metal contained in the aqueous solution are not particularly limited, and examples thereof include lithium, sodium, potassium, magnesium, calcium, and barium. The aqueous solution may contain only one alkali metal and alkaline earth metal, or two or more alkali metals and alkaline earth metals. The alkali metal and the alkaline earth metal are preferably sodium, potassium, or calcium from the viewpoint of reactivity, versatility, and the like. The aqueous solution can usually be an aqueous solution of an alkali metal salt and/or an alkaline earth metal salt. Counter ions of the alkali metal and the alkaline earth metal in the salts are not particularly limited, and may be, for example, hydroxy ions or halogen ions. Specific examples of the aqueous solution include an aqueous sodium hydroxide solution, an aqueous potassium hydroxide solution, an aqueous sodium fluoride solution, an aqueous sodium chloride solution, and an aqueous calcium chloride solution.

In addition, a concentration of the alkali metal salt or the alkaline earth metal salt may be in a range in which the amount of the alkali metal and the alkaline earth metal in the heating step which will be described below falls within a desired range.

### ▪ Heating Step

In the heating step, a composition obtained by mixing the above-described mixture with an aqueous solution containing an alkali metal and/or an alkaline earth metal is heated with substantially no solvent, thereby preparing carbon quantum dots.

Here, the total amount of the alkali metal and the alkaline earth metal in the composition (composition obtained by mixing the mixture and an aqueous solution) when the heating step is performed is only required to be 0.1 mol% or more and 30 mol% or less, and is preferably 0.5 mol% or more and 20 mol% or less, and more preferably 1 mol% or more and 10 mol% or less, with respect to the sum of the numbers of moles of carbon atoms and nitrogen atoms contained in the organic compound and the boron compound. The alkali metal and the alkaline earth metal in the composition are mainly derived from the above-described aqueous solution, but a part thereof may be derived from the mixture (for example, derived from the organic compound, the boron compound, or another compound) as described above.

In this step, the mixture and the aqueous solution are mixed and then heated. The heating method is only required to be a method that can produce the carbon quantum dots by carbonizing the organic compound and the like, and examples thereof include heating by a heater and irradiation of electromagnetic wave. The heating temperature, heating time, electromagnetic wave irradiation method, irradiation time, and the like are the same as those in the first production method.

By this step of heating, the carbon quantum dots are obtained. Note that unreacted boron compound and the like may remain around the carbon quantum dots. Thus, to isolate the carbon quantum dots, for example, the obtained component may be washed with an organic solvent or the like to purify the component by removal of unreacted materials or by-products.

### (3) Physical Property of Carbon Quantum Dot

The carbon quantum dots obtained by the first production method and the second production method described above are all solid at 1 atm and 25°C. The average particle size measured by observing the carbon quantum dots by using an atomic force microscope (AFM) is preferably 1 nm or greater and 100 nm or less, and more preferably 1 nm or greater and 80 nm or less. When the average particle size of the carbon quantum dots is in this range, characteristics as quantum dots tend to be adequately achieved. Note that the average particle size of the carbon quantum dots is preferably determined by measuring 3 or more carbon quantum dots and determining the average value of these.

Further, a maximum emission wavelength of the carbon quantum dots when irradiated with light having a wavelength of 460 nm is preferably at a wavelength of 520 nm or more and 580 nm or less, and more preferably at a wavelength of 530 nm or more and 550 nm or less. In addition, the emitted light when irradiated is preferably mainly fluorescence. When the maximum emission wavelength of fluorescence when irradiated with light having a wavelength of 460 nm is in the above range, the carbon quantum dots can be easily used as a light emitting material for a white LED, for example, as a fluorophor material for a white LED, which is excited by blue light. The maximum emission wavelength can be specified by acquiring a spectral distribution when irradiated with light having a wavelength of 460 nm using a spectrofluorophotometer or the like equipped with an integrating sphere unit.

In the carbon quantum dots, a ratio of an emission intensity at a wavelength of 420 nm to an emission intensity at a wavelength of 530 nm, i.e., (emission intensity at a wavelength of 420 nm)/(emission intensity at a wavelength of 530 nm), when irradiated with light having a wavelength of 340 nm, is preferably 0.25 or less, and more preferably 0.21 or less. The value indicates how the tail of the peak of the emission wavelength of the carbon quantum dots spreads, and it can be said that the smaller the value is, the sharper the peak of the emission wavelength is. When the value is 0.25 or less, it can be said that the emission intensity in the vicinity of a wavelength of 420 nm is low, and that light is efficiently emitted in the vicinity of a wavelength of 530 nm. That is, the carbon quantum dots can be easily used as a fluorophor material for a white LED. The emission intensity at a wavelength of 420 nm to the emission intensity at a wavelength of 530 nm when irradiated with light having a wavelength of 340 nm can be specified by acquiring a spectral distribution when irradiated with the light having a wavelength of 340 nm using a spectrofluorophotometer or the like equipped with an integrating sphere unit.

Furthermore, an internal quantum yield of the carbon quantum dots when irradiated with light having a wavelength of 460 nm is preferably 50% or more, and more preferably 55% or more. When the internal quantum yield of the carbon quantum dots is 50% or more, the carbon quantum dots can be easily used for various applications. The internal quantum yield can also be specified by acquiring a spectral distribution when irradiated with light having a wavelength of 460 nm using a spectrofluorophotometer or the like equipped with an integrating sphere unit.

The composition of preferred carbon quantum dots is not particularly limited. According to the production method for carbon quantum dots, carbon quantum dots in which the amount of carbon atoms is 10 mass% or more and 25 mass% or less, the amount of nitrogen atoms is 15 mass% or more and 35 mass% or less, the amount of boron atoms is 5 mass% or more and 30 mass% or less, and the amount of alkali metal or alkaline earth metal is 0.1 mass% or more and 30 mass% or less can be prepared.

### (4) Application of Carbon Quantum Dot

The carbon quantum dots obtained by the production method described above have excellent emission properties. Thus, the carbon quantum dots can be used in various applications. The application of the carbon quantum dots is not particularly limited and can be used for, for example, solar batteries, displays, security inks, quantum dot lasers, biomarkers, lighting materials, thermoelectric materials, photocatalysts, and separating agents for a specific substance, based on the performance of the carbon quantum dots.

Note that the carbon quantum dots described above are solid at 25°C under 1 atm but may be used in various applications in a state of solution where the carbon quantum dots are dispersed in a solvent or the like.

Note that the carbon quantum dots obtained by the above-described production method mainly emit fluorescence having a wavelength of 520 nm or more and 580 nm or less upon irradiation with exciting light in a blue wavelength region. In addition, the peak of the emission wavelength is sharp, the emission intensity is high in a wavelength range of 520 nm or more and 580 nm or less, and the emission intensity is low in other wavelength ranges. Therefore, the carbon quantum dots are very useful as a fluorophor material for a white LED.

When the carbon quantum dots (fluorophor material for a white LED) are used in a white LED, a white LED device having an excellent luminous efficiency can be obtained by combining the carbon quantum dots with a blue LED having a wavelengths of 420 nm or more and 480 nm or less.

### EXAMPLES

Hereinafter, specific examples of the present invention will be described together with comparative examples, but the present invention is not limited to these.

### [Example 1]

### (1) Preparation of carbon quantum dots

Organic compounds (0.046 g of trisodium citrate dihydrate and 0.080 g of dicyandiamide) and 0.144 g of a boron compound (boric acid) were mixed while being ground in a mortar, and thus a mixture was prepared. The powder mixture was placed in a screw-top test tube with an internal volume of 15 mL, and the screw-top test tube was sealed with a screw cap with a rubber packing. The screw-top test tube was then heated at 170°C for 1.5 hours while nitrogen was circulated in the screw-top test tube, and solid-state carbon quantum dots were synthesized. Note that the amount of nitrogen atoms in the organic compound and the amount of the boron compound with respect to the total amount of the organic compound and the boron compound are indicated in Table 1.

### (2) Evaluation of solid-state emission properties

The obtained carbon quantum dot was sandwiched in KBr plates and pressed, and a measurement sample was prepared. Then, the maximum emission wavelength and internal quantum yield when the sample was irradiated with light having a wavelength of 460 nm, and the emission intensity at a wavelength of 420 nm to the emission intensity at a wavelength of 530 nm wavelengths when irradiated with light having a wavelength of 340 nm (emission intensity at 420 nm/emission intensity at 530 nm) were measured. The measurements described above were performed using a spectrofluorophotometer FP-8500 (available from JASCO Corporation) equipped with an integrating sphere unit ILF-835. Note that the obtained carbon quantum dots emitted yellow fluorescence under irradiation with light having a wavelength of 460 nm, and that the fluorescence was immediately quenched when the irradiation with exciting light was stopped. The results are indicated in Table 1.

### [Example 2]

Organic compounds (0.051 g of tripotassium citrate monohydrate and 0.080 g of dicyandiamide) and 0.144 g of a boron compound (boric acid) were mixed by the same method as in Example 1, and thus a mixture was prepared. The mixture was heated in the same manner as in Example 1, and thus solid-state carbon quantum dots were prepared. The solid-state emission properties were evaluated for the obtained carbon quantum dots in the same manner as in Example 1. Note that the obtained carbon quantum dots emitted yellow fluorescence under irradiation with light having a wavelength of 460 nm, and that the fluorescence was immediately quenched when the irradiation with exciting light was stopped. The results are indicated in Table 1.

### [Example 3]

Organic compounds (0.051 g of tripotassium citrate monohydrate and 0.060 g of dicyandiamide) and 0.144 g of a boron compound (boric acid) were mixed by the same method as in Example 1, and thus a mixture was prepared. The mixture was heated in the same manner as in Example 1, and thus solid-state carbon quantum dots were prepared. The solid-state emission properties were evaluated for the obtained carbon quantum dots in the same manner as in Example 1. Note that the obtained carbon quantum dots emitted yellow fluorescence under irradiation with light having a wavelength of 460 nm, and that the fluorescence was immediately quenched when the irradiation with exciting light was stopped. The results are indicated in Table 1.

### [Example 4]

Organic compounds (0.030 g of citric acid and 0.080 g of dicyandiamide) and 0.144 g of a boron compound (boric acid) were mixed while being ground in a mortar, and thus a mixture was prepared. The powdery mixture was placed in a screw-top test tube having an internal volume of 15 ml, and 0.3 ml of a 10 mass% aqueous potassium hydroxide solution (amount of the aqueous solution with respect to the mass of the mixture: 129 mass%, amount of potassium with respect to the sum of the numbers of moles of carbon atoms and nitrogen atoms contained in the mixture: 9 mol%) was added thereto. The test tube was then sealed with a screw cap with a rubber packing. The screw-top test tube was then heated at 170°C for 1.5 hours while nitrogen was circulated in the screw-top test tube, and solid-state carbon quantum dots were synthesized. The solid-state emission properties were evaluated for the obtained carbon quantum dots in the same manner as in Example 1. Note that the obtained carbon quantum dots emitted yellow fluorescence under irradiation with light having a wavelength of 460 nm, and that the fluorescence was immediately quenched when the irradiation with exciting light was stopped. The results are indicated in Table 1.

### [Example 5]

Organic compounds (0.030 g of citric acid and 0.080 g of dicyandiamide), 0.144 g of a boron compound (boric acid), and 0.3 ml of a 8 mass% aqueous sodium hydroxide solution (amount of the aqueous solution with respect to the mass of the mixture: 129 mass%, amount of sodium with respect to the sum of the numbers of moles of carbon atoms and nitrogen atoms contained in the mixture: 9 mol%) were mixed in the same manner as in Example 4, and a mixture was prepared. The mixture was heated in the same manner as in Example 4, and thus solid-state carbon quantum dots were prepared. The solid-state emission properties were evaluated for the obtained carbon quantum dots in the same manner as in Example 1. Note that the obtained carbon quantum dots emitted yellow fluorescence under irradiation with light having a wavelength of 460 nm, and that the fluorescence was immediately quenched when the irradiation with exciting light was stopped. The results are indicated in Table 1.

### [Example 6]

Organic compounds (0.030 g of citric acid and 0.080 g of dicyandiamide), 0.144 g of a boron compound (boric acid), and 0.3 ml of a 2 mass% aqueous sodium hydroxide solution (amount of the aqueous solution with respect to the mass of the mixture: 120 mass%, amount of sodium with respect to the sum of the numbers of moles of carbon atoms and nitrogen atoms contained in the mixture: 2 mol%) were mixed in the same manner as in Example 4, and a mixture was prepared. The mixture was heated in the same manner as in Example 4, and thus solid-state carbon quantum dots were prepared. The solid-state emission properties were evaluated for the obtained carbon quantum dots in the same manner as in Example 1. Note that the obtained carbon quantum dots emitted yellow fluorescence under irradiation with light having a wavelength of 460 nm, and that the fluorescence was immediately quenched when the irradiation with exciting light was stopped. The results are indicated in Table 1.

### [Example 7]

Organic compounds (0.030 g of citric acid and 0.080 g of dicyandiamide), 0.144 g of a boron compound (boric acid), and 0.3 mL of a 8 mass% sodium fluoride aqueous solution (amount of the aqueous solution with respect to the mass of the mixture: 125 mass%, amount of sodium with respect to the sum of the numbers of moles of carbon atoms and nitrogen atoms contained in the mixture: 9 mol%) were mixed in the same manner as in Example 4, and a mixture was prepared. The mixture was heated in the same manner as in Example 4, and thus solid-state carbon quantum dots were prepared. The solid-state emission properties were evaluated for the obtained carbon quantum dots in the same manner as in Example 1. Note that the obtained carbon quantum dots emitted yellow fluorescence under irradiation with light having a wavelength of 460 nm, and that the fluorescence was immediately quenched when the irradiation with exciting light was stopped. The results are indicated in Table 1.

### [Example 8]

Organic compounds (0.030 g of citric acid and 0.080 g of dicyandiamide), 0.144 g of a boron compound (boric acid), and 0.3 mL of a 11 mass% sodium chloride aqueous solution (amount of the aqueous solution with respect to the mass of the mixture: 128 mass%, amount of sodium with respect to the sum of the numbers of moles of carbon atoms and nitrogen atoms contained in the mixture: 9 mol%) were mixed in the same manner as in Example 4, and a mixture was prepared. The mixture was heated in the same manner as in Example 4, and thus solid-state carbon quantum dots were prepared. The solid-state emission properties were evaluated for the obtained carbon quantum dots in the same manner as in Example 1. Note that the obtained carbon quantum dots emitted yellow fluorescence under irradiation with light having a wavelength of 460 nm, and that the fluorescence was immediately quenched when the irradiation with exciting light was stopped. The results are indicated in Table 1.

### [Example 9]

Organic compounds (0.030 g of citric acid and 0.080 g of dicyandiamide), 0.144 g of a boron compound (boric acid), and 0.3 ml of a 3 mass% calcium chloride aqueous solution (amount of the aqueous solution with respect to the mass of the mixture: 120 mass%, amount of calcium with respect to the sum of the numbers of moles of carbon atoms and nitrogen atoms contained in the mixture: 1 mol%) were mixed in the same manner as in Example 4, and a mixture was prepared. The mixture was heated in the same manner as in Example 4, and thus solid-state carbon quantum dots were prepared. The solid-state emission properties were evaluated for the obtained carbon quantum dots in the same manner as in Example 1. Note that the obtained carbon quantum dots emitted yellow fluorescence under irradiation with light having a wavelength of 460 nm, and that the fluorescence was immediately quenched when the irradiation with exciting light was stopped. The results are indicated in Table 1.

### [Comparative Example 1]

Organic compounds (0.030 g of citric acid and 0.080 g of dicyandiamide) and 0.144 g of a boron compound (boric acid) were mixed by the same method as in Example 1, and thus a mixture was prepared. The mixture was heated in the same manner as in Example 1, and thus solid-state carbon quantum dots were prepared. The solid-state emission properties were evaluated for the obtained carbon quantum dots in the same manner as in Example 1. Note that the obtained carbon quantum dots emitted blue fluorescence under irradiation with light having a wavelength of 365 nm, and that the fluorescence was immediately quenched when the irradiation with exciting light was stopped. The results are indicated in Table 1.

### [Comparative Example 2]

Organic compounds (0.030 g of citric acid and 0.080 g of dicyandiamide), 0.144 g of a boron compound (boric acid), and 0.3 mL of water were mixed by the same method as in Example 4, and thus a mixture was prepared. The mixture was heated in the same manner as in Example 4, and thus solid-state carbon quantum dots were prepared. The solid-state emission properties were evaluated for the obtained carbon quantum dots in the same manner as in Example 1. Note that the obtained carbon quantum dots emitted blue fluorescence under irradiation with light having a wavelength of 365 nm, and that the fluorescence was immediately quenched when the irradiation with exciting light was stopped. The results are indicated in Table 1.

### [Comparative Example 3]

Organic compounds (0.051 g of tripotassium citrate monohydrate and 0.031 g of dicyandiamide) and 0.100 g of a boron compound (boric acid) were mixed by the same method as in Example 1, and thus a mixture was prepared. The mixture was heated in the same manner as in Example 1, and thus solid-state carbon quantum dots were prepared. The solid-state emission properties were evaluated for the obtained carbon quantum dots in the same manner as in Example 1. Note that the obtained carbon quantum dots emitted yellow fluorescence under irradiation with light having a wavelength of 365 nm, and that the fluorescence was immediately quenched when the irradiation with exciting light was stopped. The results are indicated in Table 1.

### [Comparative Example 4]

Organic compounds (0.051 g of tripotassium citrate monohydrate and 0.120 g of dicyandiamide) and 0.144 g of a boron compound (boric acid) were mixed by the same method as in Example 1, and thus a mixture was prepared. The mixture was heated in the same manner as in Example 1, and thus solid-state carbon quantum dots were prepared. The solid-state emission properties were evaluated for the obtained carbon quantum dots in the same manner as in Example 1. Note that the obtained carbon quantum dots emitted yellow fluorescence under irradiation with light having a wavelength of 365 nm, and that the fluorescence was immediately quenched when the irradiation with exciting light was stopped. The results are indicated in Table 1.

### [Comparative Example 5]

Organic compounds (0.030 g of citric acid and 0.080 g of dicyandiamide), 0.072 g of a boron compound (boric acid), and 0.3 ml of an 8 mass% aqueous sodium hydroxide solution were mixed by the same method as in Example 4, and thus a mixture was prepared. The mixture was heated in the same manner as in Example 4, and thus solid-state carbon quantum dots were prepared. The solid-state emission properties were evaluated for the obtained carbon quantum dots in the same manner as in Example 1. Note that the obtained carbon quantum dots emitted yellow green fluorescence under irradiation with light having a wavelength of 365 nm, and that the fluorescence was immediately quenched when the irradiation with exciting light was stopped. The results are indicated in Table 1.

### [Comparative Example 6]

Organic compounds (0.051 g of tripotassium citrate monohydrate and 0.040 g of dicyandiamide) and 0.144 g of a boron compound (boric acid) were mixed by the same method as in Example 1, and thus a mixture was prepared. The mixture was heated in the same manner as in Example 1, and thus solid-state carbon quantum dots were prepared. The solid-state emission properties were evaluated for the obtained carbon quantum dots in the same manner as in Example 1. Note that the obtained carbon quantum dots emitted yellow green fluorescence under irradiation with light having a wavelength of 365 nm, and that the fluorescence was immediately quenched when the irradiation with exciting light was stopped. The results are indicated in Table 1.

### [Comparative Example 7]

Organic compounds (0.030 g of citric acid and 0.080 g of dicyandiamide), 0.144 g of a boron compound (boric acid), and 0.3 mL of water were mixed by the same method as in Example 4, and thus a mixture was prepared. The mixture was heated in the same manner as in Example 4, and thus solid-state carbon quantum dots were prepared. With the obtained carbon quantum dots, 0.3 mL of an 8 mass% aqueous sodium hydroxide solution was mixed. The mixture was heated at 170°C for 0.5 hours while nitrogen was circulated in the screw-top test tube, and solid-state carbon quantum dots subjected to alkali post-treatment were obtained. The solid-state emission properties were evaluated for the obtained carbon quantum dots in the same manner as in Example 1. Note that the obtained carbon quantum dots emitted blue green fluorescence under irradiation with light having a wavelength of 365 nm, and that the fluorescence was immediately quenched when the irradiation with exciting light was stopped. The results are indicated in Table 1.

### [Comparative Example 8]

Organic compounds (0.030 g of citric acid and 0.080 g of dicyandiamide) and 0.144 g of a boron compound (boric acid) were mixed by the same method as in Example 1, and thus a mixture was prepared. The mixture was heated in the same manner as in Example 1, and thus solid-state carbon quantum dots were prepared. With the obtained carbon quantum dots, 0.3 mL of an 8 mass% aqueous sodium hydroxide solution was mixed. The mixture was heated at 170°C for 0.5 hours while nitrogen was circulated in the screw-top test tube, and solid-state carbon quantum dots subjected to alkali post-treatment were obtained. The solid-state emission properties were evaluated for the obtained carbon quantum dots in the same manner as in Example 1. Note that the obtained carbon quantum dots emitted blue green fluorescence under irradiation with light having a wavelength of 365 nm, and that the fluorescence was immediately quenched when the irradiation with exciting light was stopped. The results are indicated in Table 1.

**[Table 1]**

| | | Organic compound | | Boron compound | | Liquid and *³ amount during heating | ( ^{*4} Amount of alkali(ne) (earth) metal | Post-treatment | Property during measurement | Maximum emission wavelength when irradiated with light having wavelength of 460 nm | Internal quantum yield when irradiated with light having wavelength of 460 nm | Emission intensity ratio (420 nm/530 nm) when irradiated with light having wavelength of 340 nm |
|---|---|---|---|---|---|---|---|---|---|---|---|---|
| | | Type and amount | ^{*1} Amount of nitrogen atom | Type and amount | ^{*2}Amount of boron compound | | | | | | | |
| | 1 | Trisodium citrate dihydrate 0.046 g + Dicyandiamide 0.080 g | 42 mass% | Boric acid 0.144 g | 53 mass% | - | 7 mol% | - | Powder | 535 nm | 80% | 0.21 |
| | 2 | Tripotassium citrate monohydrate 0.051 g + Dicyandiamide 0.080 q | 41 mass% | Boric acid 0.144 g | 52 mass% | - | 7 mol% | - | Powder | 540 nm | 54% | 0.18 |
| | 3 | Tripotassium citrate monohydrate 0.051 g + Dicyandiamide 0.060 g | 36 mass% | Boric acid 0.144 g | 56 mass% | - | 9 mol% | - | Powder | 540 nm | 59% | 0.23 |
| Examples | 4 | Citric acid 0.030 g + Dicyandiamide 0.080 g | 48 mass% | Boric acid 0.144 g | 57 mass% | KOHaq 129 mass% | 9 mol% | - | Powder | 545 nm | 50% | 0.15 |
| | 5 | Citric acid 0.030 g + Dicyandiamide 0.080 g | 48 mass% | Boric acid 0.144 g | 57 mass% | NaOHaq 129 mass% | 9 mol% | - | Powder | 540 nm | 66% | 0.13 |
| | 6 | Citric acid 0.030 g + Dicyandiamide 0.080 g | 48 mass% | Boric acid 0.144 g | 57 mass% | NaOH 120 mass% | 2 mol% | - | Powder | 535 nm | 63% | 0.21 |
| | 7 | Citric acid 0.030 g + Dicyandiamide 0.080 g | 48 mass% | Boric acid 0.144 g | 57 mass% | NaFaq 125 mass% | 9 mol% | - | Powder | 535 nm | 71% | 0.13 |
| | 8 | Citric acid 0.030 g + Dicyandiamide 0.080 q | 48 mass% | Boric acid 0.144 g | 57 mass% | NaClaq 128 mass% | 9 mol% | - | Powder | 535 nm | 61% | 0.20 |
| | 9 | Citric acid 0.030 g + Dicyandiamide 0.080 g | 48 mass% | Boric acid 0.144 g | 57 mass% | CaCl₂ aq 120 mass% | 1 mol% | - | Powder | 530 nm | 66% | 0.18 |
| | 1 | Citric acid 0.030 g + Dicyandiamide 0.080 q | 48 mass% | Boric acid 0.144 g | 57 mass% | - | - | - | Powder | 525 nm | 56 % | 0.74 |
| | 2 | Citric acid 0.030 g + Dicyandiamide 0.080 g | 48 mass% | Boric acid 0.144 g | 57 mass% | H₂O | - | - | Powder | 530 nm | 63% | 0.31 |
| | 3 | Tripotassium citrate monohydrate 0.051 g + Dicyandiamide 0.031 q | 25 mass% | Boric acid 0.100 g | 55 mass% | - | 15 mol% | - | Powder | 540 nm | 69% | 0.60 |
| Comparative Examples | 4 | Tripotassium citrate monohydrate 0.051 g + Dicyandiamide 0.120 g I | 47 mass% | Boric acid 0.144 g | 46 mass% | - | 5 mol% | - | Powder | 545 nm | 45% | 0.09 |
| | 5 | Citric acid 0.030 g + Dicyandiamide 0.080 g | 48 mass% | 3oric acid 0.072 g | 40 mass% | NaOHaq 180 mass% | 9 mol% | - | Powder | 535 nm | 51 % | 0.57 |
| | 6 | Tripotassium citrate monohydrate 0.051 g + Dicyandiamide 0.040 q 1 | 29 mass% | Boric acid 0.144 g | 61 mass% | - | 12 mol% | - | Powder | 535 nm | 69% | 0.86 |
| | 7 | Citric acid 0.030 g + Dicyandiamide 0.080 g | 48 mass% | Boric acid 0.144 g | 57 mass% | H₂O | - | NaOH Heat treatment | Powder | 535 nm | 47% | 0.32 |
| | 8 | Citric acid 0.030 g + Dicyandiamide 0.080 g | 48 mass% | Boric acid 0.144 g | 57 mass% | - | - | NaOH Heat treatment | Powder | 535 nm | 47% | 0.26 |

| | | | | | | | | | | | | |
|---|---|---|---|---|---|---|---|---|---|---|---|---|
| *1 Amount of nitrogen atoms in the organic compounds *2 Amount of the boron compound with respect to the total amount of the organic compounds and the boron compound *3 Amount of the aqueous solution with respect to the amount of the mixture *4 Amount of the alkali metal with respect to the sum of the numbers of moles of carbon atoms and nitrogen atoms in the organic compounds and the boron compound | | | | | | | | | | | | |

As shown in Table 1 above, when carbon quantum dots were prepared by mixing organic compounds containing a nitrogen atom and an alkali metal and/or alkaline earth metal and a boron compound and heating the mixture in a substantially solvent-free state, the obtained carbon quantum dots had a maximum emission wavelength in a yellow wavelength region (a wavelength region of 520 nm or more and 580 nm or less) and a high emission quantum yield, when irradiated with light having a wavelength of 460 nm (Examples 1 to 3, Comparative Examples 3 and 6). However, in the case where the amount of the boron compound was less than 50 mass% with respect to the total amount of the organic compounds and the boron compound (Comparative Example 4), the obtained carbon quantum dots had a low emission quantum yield when irradiated with light having a wavelength of 460 nm. In addition, when the amount of nitrogen atoms in the organic compounds was less than 30 mass% with respect to the organic compounds (Comparative Examples 3 and 6), the emission intensity at a wavelength of 420 nm to the emission intensity at a wavelength of 530 nm (emission intensity at 420 nm/emission intensity at 530 nm), when irradiated with light having an excitation wavelength of 340 nm, was large. It can be said that the carbon quantum dots emitted not only yellow fluorescence but also blue light. On the other hand, when the amount of nitrogen atoms in the organic compounds is within a predetermined range and the amount of the boron compound with respect to the total amount of the organic compounds and the boron compound is within a predetermined range, the value is small, and it can be said that yellow light was mainly emitted (Examples 1 to 3).

On the other hand, when neither the organic compounds nor the boron compound contained an alkali metal and/or an alkaline earth metal nor were mixed with an aqueous alkali metal solution, the maximum emission wavelength when irradiated with light having a wavelength of 460 nm was lower than the desired range, and the emission intensity at a wavelength of 420 nm to the emission intensity at a wavelength of 530 nm (emission intensity at 420 nm/emission intensity at 530 nm), when irradiated with light having an excitation wavelength of 340 nm, was also large (Comparative Example 1). In addition, also when carbon quantum dots were prepared by mixing a small amount of water containing no alkali metal and/or alkaline earth metal, the emission intensity at a wavelength of 420 nm to the emission intensity at a wavelength of 530 nm (emission intensity at 420 nm/emission intensity at 530 nm), when irradiated with light having an excitation wavelength of 340 nm, was large (Comparative Example 2).

In addition, also when carbon quantum dots were prepared by preparing a mixture of organic compounds and a boron compound, then mixing an aqueous solution containing an alkali metal and/or an alkaline earth metal, and heating the mixture with substantially no solvent, the obtained carbon quantum dots had a maximum emission wavelength in a yellow wavelength range (a wavelength range of 520 nm or more and 580 nm or less) when irradiated with light having a wavelength of 460 nm (Examples 4 to 9 and Comparative Example 5). In addition, when the amount of the boron compound with respect to the total amount of the organic compounds and the boron compound was not within the predetermined range, the emission intensity at a wavelength of 420 nm to the emission intensity at a wavelength of 530 nm (emission intensity at 420 nm/emission intensity at 530 nm), when irradiated with light having an excitation wavelength of 340 nm, was large (Comparative Example 5). On the other hand, when the amount of nitrogen atoms in the organic compounds is within a predetermined range and the amount of the boron compound with respect to the total amount of the organic compounds and the boron compound is within a predetermined range, the value is small, and carbon quantum dots that mainly emitted yellow light were obtained (Examples 4 to 9).

Further, also when carbon quantum dots were prepared, then mixed with an aqueous sodium hydroxide solution, and heat-treated, the emission intensity at a wavelength of 420 nm to the emission intensity at a wavelength of 530 nm (emission intensity at 420 nm/emission intensity at 530 nm), when irradiated with light having an excitation wavelength of 340 nm, was large (Comparative Examples 7 and 8).

The present application claims priority from the Japanese patent application No. 2022-044067 filed on March 18, 2022. The contents described in the specification of the foregoing application are all incorporated in the specification of the present application by reference.

### INDUSTRIAL APPLICABILITY

The production method for carbon quantum dots of the present invention makes it possible to easily produce carbon quantum dots having main light emission at a wavelength of from 520 nm to 580 nm when irradiated with blue light. The carbon quantum dots produced by the method can be used, for example, as an alternative material to a yellow fluorophor for a white LED. Additionally, the carbon quantum dots can be applied in various products such as various lighting materials and thermoelectric materials.

## Claims

1. A method for producing carbon quantum dots, which is a method for producing carbon quantum dots that are solid at 25°C under 1 atm, the method comprising:
preparing a mixture comprising an organic compound and a boron compound, the organic compound comprising a reactive group and not containing a boron atom; and
preparing carbon quantum dots by heating the mixture with substantially no solvent in the presence of an alkali metal and/or an alkaline earth metal,
wherein an amount of nitrogen atoms contained in the organic compound is 30 mass% or more and 50 mass% or less with respect to a total amount of the organic compound;
an amount of the boron compound is 50 mass% or more and 80 mass% or less with respect to a total amount of the organic compound and the boron compound; and
a total amount of the alkali metal and the alkaline earth metal is 0.1 mol% or more and 30 mol% or less with respect to a sum of numbers of moles of carbon atoms and nitrogen atoms contained in the organic compound and the boron compound.

2. The method for producing carbon quantum dots according to claim 1, wherein the organic compound and/or the boron compound comprises an alkali metal and/or an alkaline earth metal.

3. The method for producing carbon quantum dots according to claim 1, further comprising, after the preparation step of the mixture and before the preparation step of the carbon quantum dots, mixing an aqueous solution containing an alkali metal and/or an alkaline earth metal with the mixture,
wherein an amount of the aqueous solution is 200 mass% or less with respect to an amount of the mixture.

4. The method for producing carbon quantum dots according to any one of claims 1 to 3,
wherein the organic compound comprises a nitrogen-containing organic compound and a nitrogen-free organic compound, the nitrogen-containing organic compound containing a nitrogen atom in a molecule, and the nitrogen-free organic compound containing no nitrogen atom in a molecule.

5. The method for producing carbon quantum dots according to claim 4, wherein the nitrogen-containing organic compound is an amine compound.

6. The method for producing carbon quantum dots according to any one of claims 1 to 5, wherein the carbon quantum dots have:
when irradiated with light having a wavelength of 460 nm, a maximum emission wavelength at a wavelength of 520 nm or more and 580 nm or less;
when irradiated with light having a wavelength of 340 nm, an emission intensity at a wavelength of 420 nm to an emission intensity at a wavelength of 530 nm of 0.25 or less; and
when irradiated with light having a wavelength of 460 nm, an internal quantum yield of 50% or more.

7. The method for producing carbon quantum dots according to any one of claims 1 to 6, wherein the carbon quantum dots are a fluorophor material for a white LED.
